(19)

(11) **EP 3 259 603 B1**

(12) # EUROPÄISCHE PATENTSCHRIFT

(45) Veröffentlichungstag und Bekanntmachung des Hinweises auf die Patenterteilung:
**19.06.2019 Patentblatt 2019/25**

(21) Anmeldenummer: **16713866.8**

(22) Anmeldetag: **30.03.2016**

(51) Int Cl.:
***G01R 15/18*** *(2006.01)* ***G01R 15/20*** *(2006.01)*
***G01R 33/07*** *(2006.01)* ***H01F 27/42*** *(2006.01)*

(86) Internationale Anmeldenummer:
**PCT/EP2016/056914**

(87) Internationale Veröffentlichungsnummer:
**WO 2016/156392 (06.10.2016 Gazette 2016/40)**

(54) **STROMMESSVORRICHTUNG UND VERFAHREN ZUR BESTIMMUNG EINES ELEKTRISCHEN STROMS**

CURRENT-MEASURING DEVICE AND METHOD FOR DETERMINING AN ELECTRIC CURRENT

DISPOSITIF DE MESURE DE COURANT ET PROCÉDÉ POUR LA DÉTERMINATION D’UN COURANT ELECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **31.03.2015 DE 102015205794**

(43) Veröffentlichungstag der Anmeldung:
**27.12.2017 Patentblatt 2017/52**

(73) Patentinhaber: **Siemens Aktiengesellschaft**
**80333 München (DE)**

(72) Erfinder: **WEISS, Roland**
**91058 Erlangen (DE)**

(56) Entgegenhaltungen:
**DE-A1-102011 110 648** **US-A- 3 323 056**
**US-A- 5 241 263** **US-A1- 2010 259 246**

- **YANG YONG ET AL: "Analysis and Test of a Zero-Flux Current Sensor to Be Used in ITER", JOURNAL OF FUSION ENERGY, PLENUM PUB.CORPORATION. NEW YORK, US, Bd. 34, Nr. 3, 12. Dezember 2014 (2014-12-12), Seiten 463-468, XP035499053, ISSN: 0164-0313, DOI: 10.1007/S10894-014-9820-4 [gefunden am 2014-12-12]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 259 603 B1

## Beschreibung

Die vorliegende Erfindung betrifft eine Strommessvorrichtung sowie ein Verfahren zur Bestimmung eines elektrischen Stroms in einem Stromleiter.

Stand der Technik

Zahlreiche energietechnische Anwendungen erfordern die Messung von hohen elektrischen Strömen. Hierzu kann beispielsweise ein durch den elektrischen Strom hervorgerufenes Magnetfeld um einen elektrischen Leiter herum erfasst und ausgewertet werden. Aus einem solchen erfassten Magnetfeld kann eine Aussage über den elektrischen Strom getroffen werden, der durch den Leiter fließt. Hierzu kann beispielsweise auch ein elektrischer Leiter durch einen ringförmigen sogenannten Flusskonzentrator geführt werden. Ein solcher Flusskonzentrator besteht beispielsweise aus einem ferromagnetischen Material, wodurch sich die magnetischen Feldlinien um den stromführenden Leiter in diesem Flusskonzentrator konzentrieren. Das magnetische Feld in diesem Flusskonzentrator kann durch einen Magnetfeldsensor, wie zum Beispiel einen Hall-Sensor, in einem Spalt des Flusskonzentrators erfasst werden. Solche Flusskonzentratoren aus ferro- bzw. ferrimagnetischen Materialien bedingen jedoch ein relativ großes Gewicht des Sensors. Darüber hinaus kann es aufgrund der magnetischen Hysterese auch zu Messfehlern kommen.

Stromsensoren nach dem Kompensationsprinzip sind aus US3323056, US2010/259246, US5241263, DE102011110648, und 'Analysis and Test of a Zero-Flux Current Sensor to Be Used in ITER', Yong et al, JOURNAL OF FUSION ENERGY, 2014, Vol. 34, No. 3, S. 463-468, XP035499053, bekannt.

Es besteht daher ein Bedarf nach einer Strommessvorrichtung, sowie einem Verfahren zur Messung eines elektrischen Stroms in einem Stromleiter, das eine präzise Strommessung in dem Stromleiter ermöglicht. Darüber hinaus besteht ein Bedarf nach einer Strommessung in einem Stromleiter mit einem möglichst großen Strommessbereich. Ferner besteht ein Bedarf nach einer Strommessung in einem elektrischen Leiter mit einer möglichst geringen Empfindlichkeit gegenüber Störfeldern.

Offenbarung der Erfindung

Hierzu schafft die vorliegende Erfindung gemäß einem Aspekt eine Strommessvorrichtung ohne Magnetfeldkonzentrator zur Bestimmung eines elektrischen Stroms in einem Stromleiter. Die Strommessvorrichtung umfasst eine Mehrzahl von Magnetfeldsensoren, die um den Stromleiter herum angeordnet sind. Die Mehrzahl von Magnetfeldsensoren sind dabei dazu ausgelegt, ein Magnetfeld zu erfassen und ein zu dem erfassten Magnetfeld korrespondierendes Ausgangssignal bereitzustellen. Ferner umfasst die Strommessvorrichtung eine Kompensationsspule, die um den Stromleiter herum angeordnet ist. Dabei ist die Mehrzahl von Magnetfeldsensoren im Inneren der Kompensationsspule angeordnet. Schließlich umfasst die Strommessvorrichtung weiterhin eine Regeleinrichtung, die dazu ausgelegt ist, einen elektrischen Kompensationsstrom in der Kompensationsspule einzustellen. Dabei wird kein Magnetfeldkonzentrator oder Flusskreis aus einem ferro- oder ferrimagnetischen Material eingesetzt.

Gemäß einem weiteren Aspekt schafft die vorliegende Erfindung ein Verfahren zur Bestimmung eines elektrischen Stroms in einem Stromleiter ohne Magnetfeldkonzentrator. Das Verfahren umfasst die Schritte des Bereitstellens einer Mehrzahl von Magnetfeldsensoren um den Stromleiter und des Bereitstellens einer Kompensationsspule, die die Mehrzahl von Magnetfeldsensoren umschließt. Das Verfahren umfasst ferner die Schritte des Erfassens der von den Magnetfeldsensoren bereitgestellten Ausgangsgrößen, des Einstellens eines elektrischen Kompensationsstroms in der Kompensationsspule basierend auf den erfassten Ausgangsgrößen der Magnetfeldsensoren; und des Bestimmens der Größe eines elektrischen Stroms durch den Stromleiter basierend auf dem eingestellten Kompensationsstrom durch die Kompensationsspule. Dabei wird kein Magnetfeldkonzentrator oder Flusskreis aus einem ferro- oder ferrimagnetischen Material eingesetzt.

Der vorliegenden Erfindung liegt die Idee zugrunde, das Magnetfeld eines von einem elektrischen Strom durchflossenen Stromleiters mittels einer Mehrzahl von Magnetfeldsensoren um den Stromleiter herum zu erfassen. Dabei wird gleichzeitig in einer Kompensationsspule ein elektrischer Strom eingestellt, um das von dem Stromleiter hervorgerufene erfasste Magnetfeld zu kompensieren. Durch diese Kompensation ist eine sehr genaue Bestimmung des elektrischen Stroms durch den Stromleiter möglich.

Aufgrund des Kompensationsprinzips muss unabhängig von dem elektrischen Strom durch den Stromleiter durch die Magnetfeldsensoren jeweils nur ein relativ geringes Magnetfeld erfasst werden. Daher ist die Strommessung über einen sehr großen Messbereich hinweg möglich.

Im Gegensatz zu konventionellen Strommesswandlern mit einem Magnetfeldkonzentrator ist bei dem erfindungsgemäßen Messprinzip kein Flusskreis aus einem ferro- oder ferrimagnetischen Material erforderlich. Somit sind auch keine Messfehler aufgrund der magnetischen Hysterese in dem Flusskonzentrator zu erwarten. Darüber hinaus sinkt auch das Gewicht der Strommessvorrichtung im Vergleich zu konventionellen Strommessvorrichtungen mit Flusskonzentratoren.

Aufgrund der Verwendung von mehreren Magnetfeldsensoren um den Stromleiter herum gleichen sich auch gegebenenfalls statistische Offset-Fehler besser aus, wodurch die Genauigkeit der Strommessvorrichtung zusätzlich gesteigert werden kann.

Da sich im Inneren der Kompensationsspule bis auf die Magnetfeldsensoren in der Regel nur dia- oder paramagnetisches Material befindet, weist die Kompensationsspule auch eine sehr geringe Induktivität auf. Dies führt auch zu einer sehr großen Grenzfrequenz einer Kompensationsregelung für das Einstellen des Stroms durch die Kompensationsspule. Für die Treiber des Stroms durch die Kompensationsspule ist somit ein relativ einfacher Aufbau möglich.

Schließlich weist der erfindungsgemäße Aufbau der Strommessvorrichtung eine sehr geringe Empfindlichkeit gegenüber Fremd- und Störfeldern auf.

In einer Ausführungsform der Strommessvorrichtung ist die Mehrzahl von Magnetfeldsensoren in einer Ebene angeordnet, wobei diese Ebene senkrecht zur Stromflussrichtung durch den Stromleiter verläuft.

Gemäß einer weiteren Ausführungsform ist jedem Magnetfeldsensor der Mehrzahl von Magnetfeldsensoren ein Flächensegment der Ebene zugeordnet. Dabei wird das jeweilige von dem Magnetfeldsensor bereitgestellte Ausgangssignal mit einem Gewichtungsfaktor gewichtete, der zu der Fläche des korrespondierenden Flächensegments korrespondiert. Auf diese Weise kann auch bei nicht gleichförmig um den Stromleiter verteilten Magnetfeldsensoren eine korrekte Erfassung des durch den Stromfluss hervorgerufenen Magnetfelds um den Stromleiter erfolgen.

Gemäß einer weiteren Ausführungsform weisen alle Magnetfeldsensoren der Mehrzahl von Magnetfeldsensoren den gleichen Abstand zu einer Mittelachse des Stromleiters auf.

Gemäß einer weiteren Ausführungsform sind die Magnetfeldsensoren äquidistant um den Stromleiter herum angeordnet.

Gemäß einer weiteren Ausführungsform stellt die Regeleinrichtung den elektrischen Kompensationsstrom in der Kompensationsspule basierend auf den von der Mehrzahl von Magnetfeldsensoren bereitgestellten Ausgangsignalen ein.

Gemäß einer weiteren Ausführungsform stellt die Regeleinrichtung den Kompensationsstrom in der Kompensationsspule so ein, dass die Summe der von der Mehrzahl von Magnetfeldsensoren bereitgestellten Ausgangssignale Null wird. Werden die Ausgangssignale von den einzelnen Magnetfeldsensoren dabei unterschiedlich gewichtet, so stellt die Regeleinrichtung den Kompensationsstrom in der Kompensationsspule so ein, dass die gewichtete Summe der Ausgangssignale Null wird. Auf diese Weise ist das von den Magnetfeldsensoren zu erfassende Magnetfeld minimal, so dass eine besonders präzise Messung möglich wird.

Gemäß einer weiteren Ausführungsform weist die Kompensationsspule eine Torus-förmige Außengeometrie auf.

Gemäß einer weiteren Ausführungsform umfasst die Mehrzahl von Magnetfeldsensoren magnetoresistive (MR) Magnetfeldsensoren. Solche Magnetfeldsensoren, die nach dem magneto-resistiven Messprinzip arbeiten, ermöglichen eine sehr genaue und präzise Messung von Magnetfeldern bei kleiner, leichter und kompakter Bauweise.

Gemäß einer weiteren Ausführungsform umfasst die Strommessvorrichtung eine Auswerteeinrichtung, die dazu ausgelegt ist, den elektrischen Strom durch den Stromleiter basierend auf dem elektrischen Strom zu ermitteln, der durch die Kompensationsspule fließt.

Gemäß einer weiteren Ausführungsform wird der elektrische Strom, insbesondere der elektrische Strom, der durch die Auswerteeinrichtung bestimmt wird, aus dem Produkt des elektrischen Stroms durch die Kompensationsspule und einer Anzahl der Windungen der Kompensationsspule berechnet. Auf diese Weise kann der Strom durch den Stromleiter sehr einfach berechnet werden.

Gemäß einer weiteren Ausführungsform des Verfahrens zum Messen eines elektrischen Stroms in einem Stromleiter minimiert der Schritt zum Einstellen des elektrischen Kompensationsstroms durch die Kompensationsspule die Ausgangsgrößen der Magnetfeldsensoren. Insbesondere wird in dem Schritt zum Einstellen des elektrischen Kompensationsstroms der Strom so eingestellt, dass die Summe, insbesondere eine gegebenenfalls gewichtete Summe, der Ausgangsgrößen der Magnetfeldsensoren minimal wird.

Gemäß einer weiteren Ausführungsform werden in dem Schritt zum Einstellen des elektrischen Kompensationsstroms in der Kompensationsspule die Ausgangsgrößen der Mehrzahl von Magnetfeldsensoren mit einem Gewichtungsfaktor multipliziert. Dieser Gewichtungsfaktor kann sich dabei insbesondere aus einem Flächensegment ergeben, der dem jeweiligen Magnetfeldsensor zugeordnet ist.

Gemäß einer weiteren Ausführungsform wird in dem Schritt zum Bestimmen der Größe des elektrischen Stroms durch den Stromleiter der elektrische Strom aus einem Produkt des Kompensationsstroms durch die Kompensationsspule und eine Anzahl der Windungen der Kompensationsspule berechnet.

Weitere Ausführungsformen und Vorteile der vorliegenden Erfindung ergeben sich aus der nachfolgenden Beschreibung unter Bezug auf die beigefügten Zeichnungen. Dabei zeigen:

Figur 1: eine schematische Darstellung einer Strommessvorrichtung mit einer Mehrzahl von Magnetfeldsensoren um einen Stromleiter;

Figur 2: eine schematische Darstellung einer Strommessvorrichtung gemäß einer Ausführungsform;

Figur 3: eine schematische Darstellung eines Querschnitts durch eine Strommessvorrichtung gemäß einer Ausführungsform; und

Figur 4: eine schematische Darstellung eines Ablaufdiagramms, wie es einem Verfahren zur Messung eines elektrischen Stroms durch einen Stromleiter zugrundeliegt.

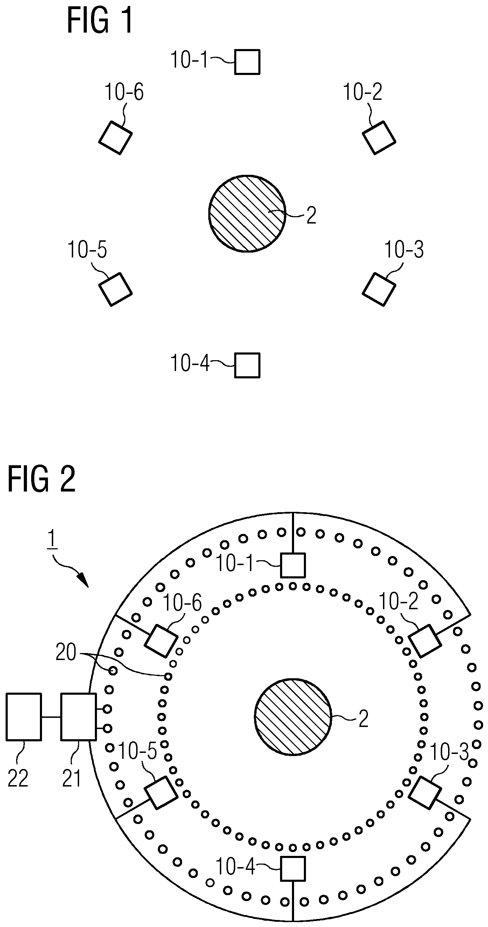

Figur 1 zeigt eine schematische Darstellung eines Hochstromsensors. Dabei sind in dieser Darstellung sechs Magnetfeldsensoren 10-i um einen Stromleiter 2 herum angeordnet. Die Magnetfeldsensoren 10-i können dabei auf einem hier nicht dargestellten Trägermaterial angeordnet werden. Wird der Stromleiter 2 von einem elektrischen Strom durchflossen, so wird hierdurch ein magnetisches Feld um den Stromleiter 2 herum hervorgerufen. Dieses Magnetfeld kann von den Magnetfeldsensoren 10-i erfasst werden. Dabei wird durch die einzelnen Magnetfeldsensoren 10-i lokal (punktweise) jeweils die Tangentialkomponente des Magnetfelds gemessen. Anschließend kann durch Summation dieser Tangentialkomponenten gemäß der folgenden Formel auf den Strom $I_L$ in dem elektrischen Leiter geschlossen werden:

$$I_L = \sum_i a_i \cdot U_i \cdot \Delta s_i$$

Dabei ist $U_i$ die Sensorausgangsspannung des jeweiligen Magnetfeldsensors 10-i, $a_i$ die Empfindlichkeit des jeweiligen Magnetfeldsensors 10-i, $\Delta s_i$ ein Streckenabschnitt im i-ten Intervall auf einer Kurve um den Stromleiter 2, auf dem die Magnetfeldsensoren 10-i liegen.

Für einen möglichst einfachen und kostengünstigen Stromsensor sollte dabei das Magnetfeld um den Stromleiter 2 mit möglichst wenigen Stützstellen, das heißt möglichst wenigen Magnetfeldsensoren 10-i angenähert werden. Damit dieses Ziel erreicht werden kann, bietet sich eine Geometrie für die Randkurve, auf der die Messung erfolgt, an, die die räumliche Anordnung des Messstroms und der Störströme gut berücksichtigt. Damit kommen als Randkurven insbesondere Kreise, Ellipsen, gleichseitige Vielecke, wie zum Beispiel Pentagone, Hexagone etc. in Frage. Wichtig für die Feststellung der Kurvenform ist dabei insbesondere, dass unter allen erdenklichen Betriebszuständen möglichst alle Sensoren in ihrer sensitiven Richtung immer eine ähnliche magnetische Feldstärke sehen und keine punktuelle Übersteuerung von Einzelkomponenten das Ergebnis verfälscht.

Bei einer einfachen Zylindergeometrie eines geraden langgestreckten Leiters 2 mit kreisförmigem Querschnitt ist dabei eine kreisförmige Anordnung der Magnetfeldsensoren 10-i mit dem stromführenden Leiter 2 im Mittelpunkt eine für die praktische Umsetzung vorteilhafte Variante, wie diese in Figur 1 dargestellt ist. Bei der Diskretisierung der Randkurve bietet es sich an, die Magnetfeldsensoren 10-i möglichst äquidistant und mit gleichem Abstand zum Mittelpunkt des elektrischen Leiters 2 anzuordnen. Bereiche der Randkurve mit hoher Krümmung bzw. einem hohen Störeinfluss können dabei bei einer Diskretisierung der Randkurve höher aufgelöst werden, das heißt in diesem Bereich kann eine größere Anzahl von Magnetfeldsensoren 10-i angeordnet werden.

Insbesondere ist anzumerken, dass die hier gewählte Anzahl von sechs Magnetfeldsensoren 10-i um den Stromleiter 2 herum nur beliebiges Beispiel darstellt. Je nach Anwendungsgebiet können auch mehr oder weniger Magnetfeldsensoren 10-i für einen Stromsensor gewählt werden.

Figur 2 zeigt eine schematische Darstellung einer Strommessvorrichtung 1 mit dem zuvor beschriebenen Messprinzip gemäß einer Ausführungsform. Die Strommessvorrichtung 1 umfasst dabei eine Mehrzahl von Magnetfeldsensoren 10-i, eine Kompensationsspule 20, sowie eine Regeleinrichtung 21. Beispielsweise kann es sich bei den Magnetfeldsensoren um magneto-resistive Magnetfeldsensoren handeln.

Für die Anordnung der Magnetfeldsensoren 10-i um den Stromleiter 2 gelten auch hier die Ausführungen, wie sie oben im Zusammenhang mit Figur 1 bereits erläutert wurden. Die Mehrzahl von Magnetfeldsensoren 10-i sind also entlang eines Kurvenverlaufs um den Stromleiter 2 herum angeordnet. In einer Ausführungsform können die Magnetfeldsensoren 10-i alle gleich weit von der Mittelachse des Stromleiters 2 beabstandet sein. Auch ist es möglich, dass alle Magnetfeldsensoren 10-i äquidistant beabstandet sind. Je nach Anwendungsfall, insbesondere von eventuell auftretenden Störeinflüssen oder einem starken Krümmungsradius, etc. kann jedoch auch eine andere Anordnung der Magnetfeldsensoren 10-i vorteilhaft sein. Die Magnetfeldsensoren 10-i sind dabei vorzugsweise auf einer (virtuellen) Ebene angeordnet, die senkrecht zu der Stromflussrichtung durch den Stromleiter 2 verläuft. Insbesondere bei einer nicht-äquidistanten bzw. ungleichförmigen Anordnung der Magnetfeldsensoren 10-i um den Stromleiter 2 herum kann dabei jedem Magnetfeldsensor 10-i ein Gewichtungsfaktor $a_i$ zugeordnet werden. Dieser Gewichtungsfaktor $a_i$ kann dabei zu einem Flächensegment korrespondieren, das dem jeweiligen Magnetfeldsensor 10-i in der (virtuellen) Ebene entspricht.

Jeder der Magnetfeldsensoren 10-i liefert dabei ein Ausgangssignal, beispielsweise eine Ausgangsspannung $U_i$, die einem von dem jeweiligen Magnetfeldsensor 10-i erfassten Magnetfeld entspricht. Alle diese Ausgangssignale (Ausgangsspannungen) $U_i$ können der Regeleinrichtung 21 zugeführt werden.

Abweichend von dem Aufbau gemäß Figur 1 weist die Strommessvorrichtung 1 weiterhin eine Kompensationsspule 20 auf. Diese Kompensationsspule 20 ist ebenfalls um den Stromleiter 2 herum angeordnet. Die Magnetfeldsensoren 10-i der Strommessvorrichtung 1 sind dabei im Inneren der Kompensationsspule 20 angeordnet. Die Kompensationsspule 20 weist dabei eine vorgegebene Anzahl n von Windungen auf.

Bei einer möglichen Ausführungsform handelt es sich bei der Kompensationsspule 20 um eine ringförmige Spule. Diese ringförmige Spule kann die Form eines Torus aufweisen. Aber auch andere Spulengeometrien zur Kompensation des Magnetfelds, das durch den elektrischen Strom durch den Stromleiter 20 hervorgerufen wird, sind möglich.

Die Kompensationsspule 20 ist mit der Regeleinrichtung 21 gekoppelt. Somit kann die Regeleinrichtung 21 einen elektrischen Strom in die Kompensationsspule 20 einspeisen. Durch den Kompensationsstrom in der Kompensationsspule 20 wird innerhalb der Kompensationsspule 20, also in dem Raum, in dem sich auch die Magnetfeldsensoren 10-i befinden, ein Magnetfeld hervorgerufen. Dieses Magnetfeld innerhalb der Kompensationsspule 20, das durch den Kompensationsstrom hervorgerufen wird, wirkt dabei dem Magnetfeld entgegen, das aufgrund des elektrischen Stroms durch den Stromleiter 2 verursacht wird. Auf diese Weise können sich das Magnetfeld aufgrund des elektrischen Stroms durch den Stromleiter 2 und das Magnetfeld aufgrund des Kompensationsstromes in der Kompensationsspule 20 im günstigsten Fall gegenseitig vollständig kompensieren. Hierzu kann die Regeleinrichtung 21 die Ausgangssignale $U_i$ der Magnetfeldsensoren 10-i auswerten, und den Kompensationsstrom durch die Kompensationsspule 20 so einstellen, dass die Ausgangssignale $U_i$ der Magnetfeldsensoren 10-i minimal werden. Hierzu betrachtet die Regeleinrichtung 21 vorzugsweise die Summe aller Ausgangssignale $U_i$ der einzelnen Magnetfeldsensoren 10-i. Werden die einzelnen Ausgangssignale $U_i$ der Magnetfeldsensoren 10-i dabei unterschiedlich gewichtet, so kann die Regeleinrichtung 21 auch die entsprechend gewichtete Summe der Ausgangssignale $U_i$ für das Regeln des Kompensationsstromes durch die Kompensationsspule 20 berücksichtigen.

Vorzugsweise regelt die Regeleinrichtung 21 den Kompensationsstrom durch die Kompensationsspule 20 so ein, dass die (gewichtete) Summe der Ausgangssignale $U_i$ der Magnetfeldsensoren 10-i minimal, insbesondere möglichst Null wird. Hierzu ist es durchaus möglich, dass einzelne Magnetfeldsensoren 10-i jeweils ein von Null verschiedenes Ausgangssignal $U_i$ ausgeben und dennoch die (gewichtete) Summe aller Ausgangssignale nach Einregeln des Kompensationsstromes durch die Kompensationsspule 20 zu Null wird.

Da sich das Magnetfeld aufgrund des elektrischen Stroms durch den Stromleiter 2 und das Magnetfeld aufgrund des Kompensationsstroms durch die Kompensationsspule 20 gegenseitig abschwächen und im günstigsten Falle vollständig kompensieren, müssen die Magnetfeldsensoren 10-i nur ein relativ geringes Magnetfeld erfassen. Ein steigender Strom durch den Stromleiter 2 kann durch Erhöhen des Kompensationsstroms durch die Kompensationsspule 2 ausgeglichen werden. Auf diese Weise ist es möglich, mit der beschriebenen Strommessvorrichtung 1 elektrische Ströme durch den Stromleiter 2 über einen großen Messbereich hinweg sehr präzise zu erfassen. Insbesondere ist eine Messung von elektrischen Strömen zwischen 40 A und 100 A sehr gut möglich. Aber auch geringere oder höhere Ströme können mit der Strommessvorrichtung 1 bei entsprechender Kompensation des Magnetfelds durch die Kompensationsspule 2 sehr gut erfasst und gemessen werden.

Die Regeleinrichtung 21 erfasst dabei, wie zuvor bereits beschrieben, die (gewichtete) Summe aller Ausgangssignale $U_i$ der Magnetfeldsensoren 10-i und regelt daraufhin den Kompensationsstrom durch die Kompensationsspule 20 so ein, dass die (gewichtete) Summe der Ausgangssignale $U_i$ der Magnetfeldsensoren 10-i minimal, bestenfalls Null wird. In diesem Fall kann der elektrische Strom durch den Stromleiter 2 sehr einfach aus dem Produkt der Windungszahl n der Kompensationsspule 20 und dem eingestellten Kompensationsstrom $I_k$ berechnet werden. Hierzu kann die Strommessvorrichtung 1 ferner eine Auswerteeinrichtung 22 umfassen, die basierend auf dem elektrischen Kompensationsstrom durch die Kompensationsspule 20 den elektrischen Strom durch den Stromleiter 2 bestimmt. Insbesondere kann die Auswerteeinrichtung 22 bei einer bekannten Anzahl n von Windungen der Kompensationsspule 20 durch Messung des Kompensationsstroms durch die Kompensationsspule 20 den Strom durch den elektrischen Leiter 2 aus dem Produkt des Kompensationsstroms durch die Kompensationsspule 20 und der Windungsanzahl n der Kompensationsspule berechnen. Anschließend kann die Auswerteeinrichtung 22 ein analoges oder digitales Ausgangssignal bereitstellen, das zu dem ermittelten elektrischen Strom durch den Stromleiter 2 korrespondiert.

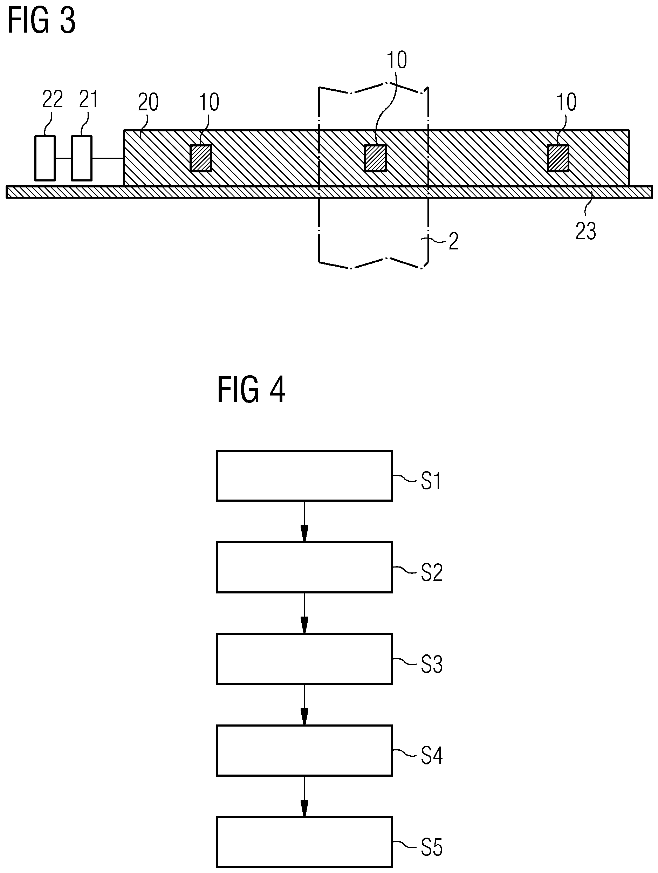

Figur 3 zeigt eine schematische Darstellung eines Querschnitts durch eine Strommessvorrichtung 1 gemäß einer Ausführungsform. Wie dabei zu erkennen ist, sind die Magnetfeldsensoren 10-i im Inneren der Kompensationsspule 20 angeordnet. Kompensationsspule 20 und auch die einzelnen Magnetfeldsensoren 10-i können dabei auf einem geeigneten Träger 23 angeordnet sein. Auch die Regeleinrichtung 21 und die Auswerteeinrichtung 22 können auf diesem Träger 23 angeordnet sein. Die einzelnen Windungen der Kompensationsspule 20 verlaufen dabei, wie in Figur 3 dargestellt, so, dass sich das Magnetfeld aufgrund eines elektrischen Stroms durch den Stromleiter 2 und das Magnetfeld aufgrund des Kompensationsstroms durch die Kompensationsspule 20 gegenseitig kompensieren können.

Figur 4 zeigt eine schematische Darstellung eines Ablaufdiagramms, wie es einem Verfahren zur Bestimmung eines elektrischen Stroms in einem Stromleiter gemäß einer Ausführungsform zugrunde liegt. Zunächst wird in einem Schritt S1 eine Mehrzahl von Magnetfeldsensoren 10-i bereitgestellt, die um den Stromleiter 2 angeordnet sind. Weiterhin wird in Schritt S2 eine Kompensationsspule 20 bereitgestellt, die die Mehrzahl von Magnetfeldsensoren 10-i umschließt.

Daraufhin können in Schritt S3 die von den Magnetfeldsensoren bereitgestellten Ausgangsgrößen erfasst werden. Diese Ausgangsgrößen der Magnetfeldsensoren 10-i korrespondieren dabei zu dem von den jeweiligen Magnetfeldsensoren 10-i erfassten Magnetfeldern. Insbesondere kann es sich bei den Ausgangsgrößen $U_i$ um eine Spannung handeln, die zu dem von den Magnetfeldsensoren erfassten Magnetfeld korrespondiert.

In Schritt S4 wird daraufhin in der Kompensationsspule 20 ein elektrischer Kompensationsstrom eingestellt. Der eingestellte Kompensationsstrom durch die Kompensationsspule 20 wird dabei insbesondere basierend auf den Ausgangsgrößen der Magnetfeldsensoren eingestellt. Insbesondere wird der Kompensationsstrom durch die Kompensationsspule 20 so eingestellt, dass die Summe, insbesondere die gewichtete Summe, der Ausgangsgrößen $U_i$ der Magnetfeldsensoren 10-i minimal, vorzugsweise Null wird. Daraufhin kann in Schritt S5 die Größe des elektrischen Stroms durch den Stromleiter 2 basierend auf dem eingestellten Kompensationsstrom durch die Kompensationsspule 20 berechnet werden. Hierzu kann beispielsweise der eingestellte Kompensationsstrom durch die Kompensationsspule 20 mit einer bekannten Anzahl n von Windungen der Kompensationsspule 20 multipliziert werden.

Zusammenfassend betrifft die vorliegende Erfindung eine Strommessvorrichtung zur galvanisch entkoppelten Messung von hohen Strömen durch einen Stromleiter. Hierzu wird um den Stromleiter eine Mehrzahl von Magnetfeldsensoren angeordnet. Ferner umfasst die Strommessvorrichtung eine Kompensationsspule, die die Magnetfeldsensoren umschließt, und in der ein Kompensationsstrom eingestellt werden kann. Durch Einregeln des Kompensationsstroms durch die Kompensationsspule können sich das Magnetfeld aufgrund des zu messenden elektrischen Stroms durch den Stromleiter und des Magnetfelds aufgrund des elektrischen Kompensationsstroms durch die Kompensationsspule weitestgehend kompensieren. Dies ermöglicht eine sehr präzise und störungsfreie Messung von hohen elektrischen Strömen über einen großen Dynamikbereich hinweg.

**Patentansprüche**

1. Strommessvorrichtung (1) ohne Magnetfeldkonzentrator zur Bestimmung eines elektrischen Stroms in einem Stromleiter (2), mit:

   einer Mehrzahl von Magnetfeldsensoren (10-i), die um den Stromleiter (2) angeordnet sind, und die dazu ausgelegt sind ein zu einem erfassten Magnetfeld korrespondierendes Ausgangsignal bereitzustellen;
   einer Kompensationsspule (20), die um den Stromleiter (2) angeordnet ist, wobei die Mehrzahl von Magnetfeldsensoren (10-i) im Inneren der Kompensationsspule (20) angeordnet sind; und
   einer Regeleinrichtung (21), die dazu ausgelegt ist, einen elektrischen Kompensationsstrom in der Kompensationsspule (20) einzustellen,
   wobei kein Magnetfeldkonzentrator oder Flusskreis aus einem ferro- oder ferrimagnetischen Material eingesetzt wird.

2. Strommessvorrichtung (1) nach Anspruch 1, wobei die Mehrzahl von Magnetfeldsensoren (10-i) in einer Ebene angeordnet ist, die senkrecht zur Stromflussrichtung durch den Stromleiter (2) verläuft.

3. Strommessvorrichtung (1) nach Anspruch 2, wobei jedem Magnetfeldsensor (10-i) der Mehrzahl von Magnetfeldsensoren (10-i) ein Flächensegment der Ebene zugeordnet ist, und das von dem jeweiligen Magnetfeldsensor (10-i) bereitgestellte Ausgangssignal mit einem zu der Fläche des korrespondierenden Flächensegments Gewichtungsfaktor gewichtet wird.

4. Strommessvorrichtung (1) nach einem der Ansprüche 1 bis 3, wobei alle Magnetfeldsensoren (10-i) der Mehrzahl von Magnetfeldsensoren (10-i) den gleichen Abstand zu einer Mittelachse des Stromleiters (2) aufweisen.

5. Strommessvorrichtung (1) nach einem der Ansprüche 1 bis 4, wobei die Magnetfeldsensoren (10-i) äquidistant um den Stromleiter (2) angeordnet sind.

6. Strommessvorrichtung (1) nach einem der Ansprüche 1 bis 5, wobei die Regeleinrichtung (21) den elektrischen Kompensationsstrom in der Kompensationsspule (20) basierend auf den von der Mehrzahl von Magnetfeldsensoren (10-i) bereitgestellten Ausgangsignalen einstellt.

7. Strommessvorrichtung (1) nach einem der Ansprüche 1 bis 6, wobei die Regeleinrichtung (21) den Kompensationsstrom in der Kompensationsspule (20) so einstellt, dass die Summe der von der Mehrzahl von Magnetfeldsensoren (10-i) bereitgestellten Ausgangssignale Null wird.

8. Strommessvorrichtung (1) nach einem der Ansprüche 1 bis 7, wobei die Kompensationsspule (20) eine Torus-förmige Außengeometrie aufweist.

9. Strommessvorrichtung (1) nach einem der Ansprüche 1 bis 8, wobei die Mehrzahl von Magnetfeldsensoren (10-i) magneto-resistive Magnetfeldsensoren umfassen.

10. Strommessvorrichtung (1) nach einem der Ansprüche 1 bis 9, ferner umfassend eine Auswerteeinrichtung (22), die dazu ausgelegt ist, den elektrischen Strom durch den Stromleiter (2) basierend auf dem elektrischen Strom zu ermitteln, der durch die Kompensationsspule (20) fließt.

**11.** Strommessvorrichtung (1) nach Anspruch 10, wobei der elektrische Strom durch den Stromleiter sich aus dem Produkt des elektrischen Stroms durch die Kompensationsspule und der (einer) Anzahl der Windungen der Kompensationsspule ergibt.

**12.** Verfahren zum Bestimmung eines elektrischen Stroms in einem Stromleiter (2) ohne Magnetfeldkonzentrator, mit den Schritten:

Bereitstellen (S1) einer Mehrzahl von Magnetfeldsensoren (10-i) um den Stromleiter (2);
Bereitstellen (S2) einer Kompensationsspule (20), die die Mehrzahl von Magnetfeldsensoren (10-i) umschließt;
Erfassen (S3) der von den Magnetfeldsensoren (10-i) bereitgestellten Ausgangsgrößen;
Einstellen (S4) eines elektrischen Kompensationsstroms in der Kompensationsspule (20) basierend auf den erfassten Ausgangsgrößen der Magnetfeldsensoren (10-i);
Bestimmen (S5) der Größe eines elektrischen Stroms durch den Stromleiter (2) basierend auf dem eingestellten Kompensationsstrom durch die Kompensationsspule (20),
wobei kein Magnetfeldkonzentrator oder Flusskreis aus einem ferro- oder ferrimagnetischen Material eingesetzt wird.

**13.** Verfahren nach Anspruch 12, wobei der Schritt (S4) zum Einstellen des elektrischen Kompensationsstroms durch die Kompensationsspule (20) die Ausgangsgrößen der Magnetfeldsensoren (10-i) minimiert.

**14.** Verfahren nach Anspruch 12 oder 13, wobei der Schritt zum Einstellen (S4) des elektrischen Kompensationsstroms die die Ausgangsgrößen der Mehrzahl von Magnetfeldsensoren (10-i) mit einem Gewichtungsfaktor multipliziert.

**15.** Verfahren nach einem der Ansprüche 12 bis 14, wobei der Schritt (S5) zum Bestimmen der Größe des elektrischen Stroms durch den Stromleiter (2) den elektrischen Strom aus einem Produkt des Kompensationsstroms durch die Kompensationsspule (20) und einer Anzahl der Windungen der Kompensationsspule (20) berechnet.

## Claims

**1.** Current-measuring device (1) without magnetic field concentrator for determining an electric current in an electrical conductor (2), with:

a plurality of magnetic-field sensors (10-i) arranged around the electrical conductor (2) and configured to provide an output signal corresponding to a detected magnetic field;
a compensation coil (20) arranged around the electrical conductor (2), wherein the plurality of magnetic-field sensors (10-i) are arranged in the interior of the compensation coil (20); and
a controller (21) configured to set an electric compensation current in the compensation coil (20),
wherein no magnetic field concentrator or flow circuit made of a ferromagnetic or ferrimagnetic material is used.

**2.** Current-measuring device (1) according to claim 1, wherein the plurality of magnetic-field sensors (10-i) is arranged in a plane extending perpendicular to the direction of current flow through the electrical conductor (2).

**3.** Current-measuring device (1) according to claim 2, wherein a surface segment of the plane is assigned to each magnetic-field sensor (10-i) of the plurality of magnetic-field sensors (10-i), and the output signal provided by the respective magnetic-field sensor (10-i) is weighted with a weighting factor corresponding to the surface of the corresponding surface segment.

**4.** Current-measuring device (1) according to one of claims 1 to 3, wherein all the magnetic-field sensors (10-i) of the plurality of magnetic-field sensors (10-i) have the same distance to a centre axis of the electrical conductor (2).

**5.** Current-measuring device (1) according to one of claims 1 to 4, wherein the magnetic-field sensors (10-i) are arranged equidistantly around the electrical conductor (2).

**6.** Current-measuring device (1) according to one of claims 1 to 5, wherein the controller (21) sets the electric compensation current in the compensation coil (20) based on the output signals provided by the plurality of magnetic-field sensors (10-i).

**7.** Current-measuring device (1) according to one of claims 1 to 6, wherein the controller (21) sets the compensation current in the compensation coil (20) such that the sum of the output signals provided by the plurality of magnetic-field sensors (10-i) is zero.

**8.** Current-measuring device (1) according to one of claims 1 to 7, wherein the compensation coil (20) has a torus-shaped outer geometry.

**9.** Current-measuring device (1) according to one of claims 1 to 8, wherein the plurality of magnetic-field sensors (10-i) comprises magnetoresistive magnetic-field sensors.

**10.** Current-measuring device (1) according to one of claims 1 to 9, furthermore comprising an evaluation facility (22) configured to determine the electric current through the electrical conductor (2) based on the electric current flowing through the compensation coil (20).

**11.** Current-measuring device (1) according to claim 10, wherein the electric current through the electrical conductor is obtained from the product of the electric current through the compensation coil and the (a) number of windings in the compensation coil.

**12.** A method for determining an electric current in an electrical conductor (2) without a magnetic field concentrator, with the steps:

provision (S1) of a plurality of magnetic-field sensors (10-i) around the electrical conductor (2);
provision (S2) of a compensation coil (20) surrounding the plurality of magnetic-field sensors (10-i);
detection (S3) of the output variables provided by the magnetic-field sensors (10-i);
setting (S4) an electric compensation current in the compensation coil (20) based on the detected output variables of the magnetic-field sensors (10-i);
determination (S5) of the magnitude of an electric current through the electrical conductor (2) based on the set compensation current through the compensation coil (20),
wherein no magnetic field concentrator or flow circuit made of a ferromagnetic or ferrimagnetic material is used.

**13.** Method according to claim 12, wherein the step (S4) for setting the electric compensation current through the compensation coil (20) minimises the output variables of the magnetic-field sensors (10-i).

**14.** Method according to claim 12 or 13, wherein the step for setting (S4) the electric compensation current multiplies the output variables of the plurality of magnetic-field sensors (10-i) by a weighting factor.

**15.** Method according to one of claims 12 to 14, wherein the step (S5) for determining the magnitude of the electric current through the electrical conductor (2) calculates the electric current from a product of the compensation current through the compensation coil (20) and a number of windings in the compensation coil (20).

**Revendications**

**1.** Dispositif de mesure de courant (1) sans concentrateur de champ magnétique destiné à déterminer un courant électrique dans un conducteur de courant (2), comprenant :

une pluralité de capteurs de champ magnétique (10-i) qui sont disposés autour du conducteur de courant (2) et qui sont conçus pour fournir un signal de sortie correspondant à un champ magnétique détecté,
une bobine de compensation (20) qui est disposée autour du conducteur de courant (2), dans lequel la pluralité de capteurs de champ magnétique (10-i) sont disposés à l'intérieur de la bobine de compensation (20), et
un moyen de réglage (21) qui est conçu pour régler un courant de compensation électrique dans la bobine de compensation (20),
dans lequel aucun concentrateur de champ magnétique ni circuit de flux magnétique constitué d'un matériau ferro- ou ferrimagnétique n'est utilisé.

**2.** Dispositif de mesure de courant (1) selon la revendication 1, dans lequel la pluralité de capteurs de champ magnétique (10-i) sont disposés dans un plan qui est perpendiculaire au sens de circulation du courant à travers le conducteur de courant (2).

**3.** Dispositif de mesure de courant (1) selon la revendication 2, dans lequel chaque capteur de champ magnétique (10-i) de la pluralité de capteurs de champ magnétique (10-i) est affecté à un segment de surface du plan, et le signal de sortie fourni par le capteur de champ magnétique (10-i) respectif est pondéré avec un facteur de pondération associé à la surface du segment de surface correspondant.

**4.** Dispositif de mesure de courant (1) selon l'une des revendications 1 à 3, dans lequel tous les capteurs de champ magnétique (10-i) de la pluralité des capteurs de champ magnétique (10-i) ont le même espacement par rapport à un axe médian du conducteur de courant (2).

**5.** Dispositif de mesure de courant (1) selon l'une des revendications 1 à 4, dans lequel les capteurs de champ magnétique (10-i) sont agencés à égale distance autour du conducteur de courant (2).

**6.** Dispositif de mesure de courant (1) selon l'une des revendications 1 à 5, dans lequel le moyen de réglage (21) règle le courant de compensation électrique dans la bobine de compensation (20) sur la base des signaux de sortie fournis par la pluralité des capteurs de champ magnétique (10-i) .

**7.** Dispositif de mesure de courant (1) selon l'une des revendications 1 à 6, dans lequel le moyen de réglage (21) règle le courant de compensation dans la bobine de compensation (20) de telle manière que la somme des signaux de sortie fournis par la pluralité des capteurs de champ magnétique (10-i) soit égale à zéro.

**8.** Dispositif de mesure de courant (1) selon l'une des revendications 1 à 7, dans lequel la bobine de compensation (20) a une géométrie extérieure de forme toroïdale.

**9.** Dispositif de mesure de courant (1) selon l'une des revendications 1 à 8, dans lequel la pluralité des capteurs de champ magnétique (10-i) comprennent des capteurs de champ magnétique magnétorésistifs.

**10.** Dispositif de mesure de courant (1) selon l'une des revendications 1 à 9, comprenant en outre un moyen d'évaluation (22) qui est conçu de manière à déterminer le courant électrique circulant à travers le conducteur de courant (2) sur la base du courant électrique qui circule à travers la bobine de compensation (20).

**11.** Dispositif de mesure de courant (1) selon la revendication 10, dans lequel le courant électrique circulant à travers le conducteur de courant électrique s'obtient par le produit du courant électrique circulant à travers la bobine de compensation et du nombre de spires de la bobine de compensation.

**12.** Procédé pour déterminer un courant électrique dans un conducteur de courant (2) sans utiliser de concentrateur de champ magnétique, comprenant les étapes suivantes :

fourniture (S1) d'une pluralité de capteurs de champ magnétique (10-i) autour du conducteur de courant (2) fourniture (S2) d'une bobine de compensation (20) qui entoure la pluralité de capteurs de champ magnétique (10-i),
détection (S3) de grandeurs de sortie fournies par les capteurs de champ magnétique (10-i),
réglage (S4) d'un courant de compensation électrique dans la bobine de compensation (20) sur la base des grandeurs de sortie détectées des capteurs de champ magnétique (10-i), et
détermination (S5) de l'intensité d'un courant électrique circulant à travers le conducteur de courant (2) sur la base du courant de compensation réglé à travers la bobine de compensation (20),
dans lequel aucun concentrateur de champ magnétique ni circuit de flux magnétique constitué d'un matériau ferro- ou ferrimagnétique n'est utilisé.

**13.** Procédé selon la revendication 12, dans lequel l'étape (S4) de réglage du courant de compensation électrique à travers la bobine de compensation (20) minimise les grandeurs de sortie des capteurs de champ magnétique (10-i) .

**14.** Procédé selon la revendication 12 ou 13, dans lequel l'étape (S4) de réglage du courant de compensation électrique multiplie par un facteur de pondération les grandeurs de sortie de la pluralité des capteurs de champ magnétique (10-i).

**15.** Procédé selon l'une des revendications 12 à 14, dans lequel l'étape (S5) de détermination de l'intensité du courant électrique circulant à travers le conducteur de courant (2) calcule le courant électrique par le produit du courant de compensation à travers la bobine de compensation (20) et du nombre de spires de la bobine de compensation (20).

FIG 1
10-1
10-6
10-2
2
10-5
10-3
10-4

FIG 2
1
10-1
10-6
10-2
20
2
22
21
10-5
10-3
10-4

FIG 3

22
21
20
10
10
10
2
23

FIG 4

S1
S2
S3
S4
S5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 3323056 A
- US 2010259246 A
- US 5241263 A
- DE 102011110648


### In der Beschreibung aufgeführte Nicht-Patentliteratur


- **YONG et al.** Analysis and Test of a Zero-Flux Current Sensor to Be Used in ITER. *JOURNAL OF FUSION ENERGY,* 2014, vol. 34 (3), 463-468